# EUROPEAN PATENT APPLICATION

(11) **EP 2 428 975 A2**
(43) Date of publication of application: **14.03.2012**
(21) Application number: 10191015.6
(22) Date of filing: 12.11.2010
(51) Int. Cl.: H01J 37/32

(54) **Plasma texturing reaction apparatus**

(30) Priority: 13.09.2010 KR 20100089338
(71) Applicant: Semi-Materials Co., Ltd, Seongnam-si 463-825 (KR)
(72) Inventor: Park, Kun Joo, YongIn-si (KR); Kim, Gi Hong, Daegu-si (KR)
(74) Representative: Neobard, William John

(57) **Abstract**

A plasma texturing reaction apparatus includes a chamber including a dielectric window and a chamber body and receiving a solar cell wafer to be textured, a polygonal induction coil provided at an outer upper portion of the dielectric window to generate a magnetic field for generating plasma, a high frequency low power supply unit that supplies a cathode of the chamber with high frequency power corresponding to process conditions, and a high frequency source power supply unit that supplies the polygonal induction coil with high frequency power.

## Description

The present invention relates to plasma texturing. Embodiments relate to a plasma texturing reaction apparatus which can improve the manufacturing efficiency and quality of a solar cell by increasing the density and uniformity of plasma ions and appropriately controlling ion energy when conducting plasma texturing through dry etching on a solar cell wafer to increase a light absorption amount of available light to the inside of the solar cell by reducing a light reflection amount on the surface of the solar cell.

A solar cell is a photoelectric element which converts light energy into electrical energy. The solar cell is considered as a clean energy source which can overcome problems such as environmental pollution, high fuel cost, etc. caused by the use of fossil fuel energy.

Recently, research has been actively conducted to improve the photoelectric conversion efficiency of a solar cell. As a way of improving the photoelectric conversion efficiency of a solar cell, wet chemical texturing is conducted on a solar cell wafer so as to decrease a light reflection amount on the surface of a solar cell and increase a light absorption amount of available light to the inside of the solar cell. By this fact, pyramid shapes with a size of 4∼10 µm are formed on the surface of the solar cell wafer.

In the case where surface texturing is conducted through wet chemical etching as described above, both surfaces of the solar cell wafer are etched. Generally, while it is required that the solar cell wafer have a thickness of no less than 200 µm, if the surface texturing through wet chemical etching is conducted for an ultrathin wafer (a solar cell wafer with a thickness of no greater than 200 µm), the breakage of the wafer may be caused as both surfaces of the wafer are etched. As a consequence, it is difficult to apply the surface texturing to an ultrathin wafer.

For this reason, plasma texturing has been spotlighted as an alternative of the wet chemical texturing.

As well known in the art, plasma is called a fourth material state and is a gas that has become partially ionized. Such plasma has conductivity by particles which are electrically neutral but positively and negatively charged, and is sensitive to an electromagnetic field. In this regard, a technology of controlling an electromagnetic field applied to the plasma may be applied to a solar cell texturing process.

A plasma reaction apparatus may be classified into a solenoid type plasma reaction apparatus, a planar type plasma reaction apparatus and a dome type plasma reaction apparatus according to an antenna and a dielectric window. According to the solenoid type plasma reaction apparatus, since an inductance value is relatively high and a sputtering problem due to a high voltage occurs, efficiency may be reduced. According to the planar type plasma reaction apparatus, since the distance between a plasma source and a wafer is short, it may be difficult to independently adjust ion energy reaching the surface of the wafer. According to the dome type plasma reaction apparatus, since the area of a substrate is increased, it may be difficult to ensure a uniform etching rate.

Furthermore, a conventional planar inductively coupled plasma system includes a cylindrical induction coil in consideration that a semiconductor wafer has a circular shape. However, since a solar cell wafer has a rectangular or square shape, when using the conventional plasma reaction apparatus, it may be difficult to ensure a uniform etching rate across the wafer.

Accordingly, embodiments have been made in an effort to solve the problems occurring in the related art.

Embodiments increase the density and uniformity of plasma ions and appropriately control ion energy by using a square induction coil when conducting plasma texturing through dry etching on a solar cell wafer.

In one aspect of the present invention, there is provided a plasma texturing reaction apparatus including: a chamber including a dielectric window and a chamber body, and receiving a solar cell wafer to be textured; a polygonal induction coil provided at an outer upper portion of the dielectric window to generate a magnetic field for generating plasma; a high frequency low power supply unit that supplies a cathode of the chamber with high frequency power corresponding to process conditions; and a high frequency source power supply unit that supplies the polygonal induction coil with high frequency power.

In the drawings
FIG. 1 is a block diagram illustrating a plasma texturing reaction apparatus embodying the present invention;
FIG. 2 is a schematic view illustrating an induction coil manufactured in a polygonal shape useable in an embodiment of the present invention;
FIG. 3 is a plan view illustrating an induction coil useable in another embodiment of the present invention;
FIG. 4 is a schematic view illustrating an induction coil useable in another embodiment of the present invention;
FIG. 5 to FIGS. 7A to 7D are plan views illustrating an induction coil useable in another embodiment of the present invention;
FIG. 8 is a diagram illustrating a high frequency low power supply unit useable with another embodiment of the present invention;
FIG. 9 is a graph illustrating an experimental result for reflectivity of a solar cell wafer in the case of using a plasma texturing reaction apparatus in accordance with an embodiment of the present invention; and
FIG. 10 is a graph illustrating an experimental result for uniformity of a solar cell wafer in the case of using a plasma texturing reaction apparatus of an embodiment.

Reference will now be made in greater detail to an embodiment of the present invention, an example of which is illustrated in the accompanying drawings.

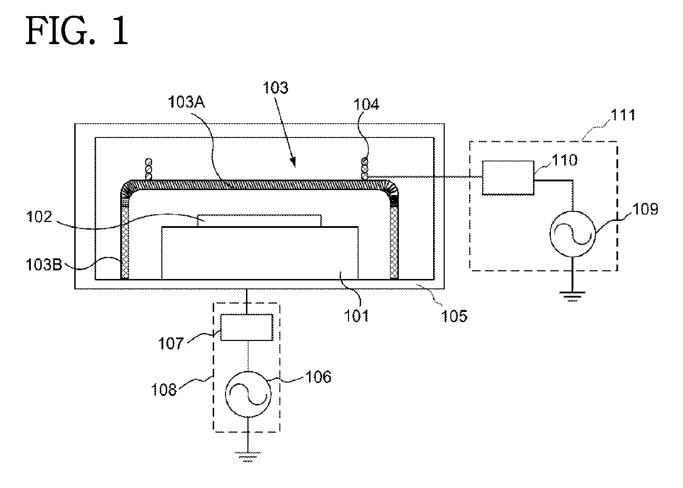

FIG. 1 is a block diagram illustrating a plasma texturing reaction apparatus in accordance with an embodiment of the present invention. Referring to FIG. 1, the plasma texturing reaction apparatus includes a chamber 103, a polygonal induction coil 104, a high frequency low power supply unit 108, and a high frequency source power supply unit 111. The chamber 103 includes a dielectric window 103A and a chamber body 103B and receives a solar cell wafer 102 to be textured. The polygonal induction coil 104 is provided at an outer upper portion of the dielectric window 103A to generate a magnetic field for generating plasma. The high frequency low power supply unit 108 supplies a cathode 101 of the chamber 103 with high frequency power corresponding to process conditions. The high frequency source power supply unit 111 supplies the induction coil 104 with high frequency power. Reference numeral 105 denotes a process module.

The high frequency power generated by a high frequency power generator 106 of the high frequency low power supply unit 108 is supplied to the cathode 101, on which the solar cell wafer 102 to be textured is loaded, through a high frequency matching section 107. Thus, the cathode 101 is maintained in a negative potential state, and the intensity of ion energy and ion density are determined.

Simultaneously to this, the high frequency power generated by a high frequency power generator 109 of the high frequency source power supply unit 111 is supplied to the induction coil 104, which is installed above the solar cell wafer 102, through a high frequency matching section 110. The induction coil 104 is not limited to a specific type induction coil. The embodiment of the present invention employs an ICP (Inductively Coupled Plasma) induction coil.

Thus, a longitudinal magnetic field is formed around the induction coil 104 by a high frequency current supplied to the induction coil 104. As a transverse electric field is formed in the plasma by the magnetic field, electrons are accelerated. The accelerated electrons obtain energy from the electromagnetic field by passing through a skin depth, are introduced into the plasma, and collide with accelerated particles, so that gas introduced into the chamber 103 is ionized, resulting in the generation of high density plasma.

The induction coil 104 has a polygonal (e.g., a rectangular or a square) shape in order to ensure a uniform etching rate across the solar cell wafer 102 having a rectangular shape.

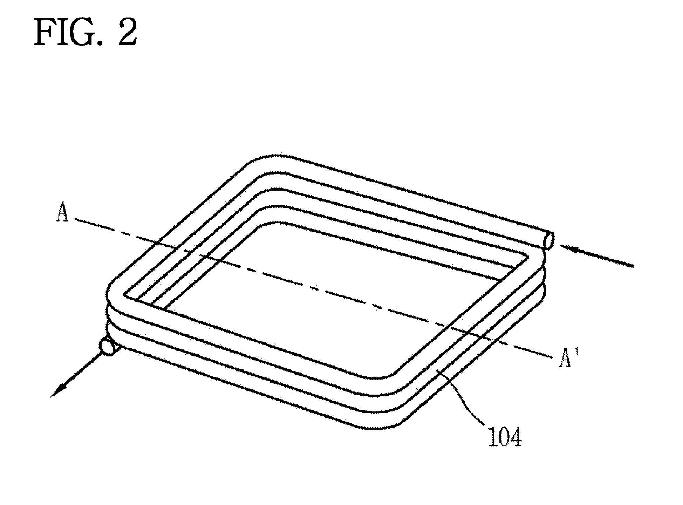

FIG. 2 is a schematic view illustrating the induction coil manufactured in the above shape in accordance with the embodiment of the present invention, which illustrates an example of a structure in which a coil is wound three times in a rectangular shape. The induction coil 104 illustrated in FIG. 1 is a section taken along line A-A' which is drawn in the induction coil 104 illustrated in FIG. 2.

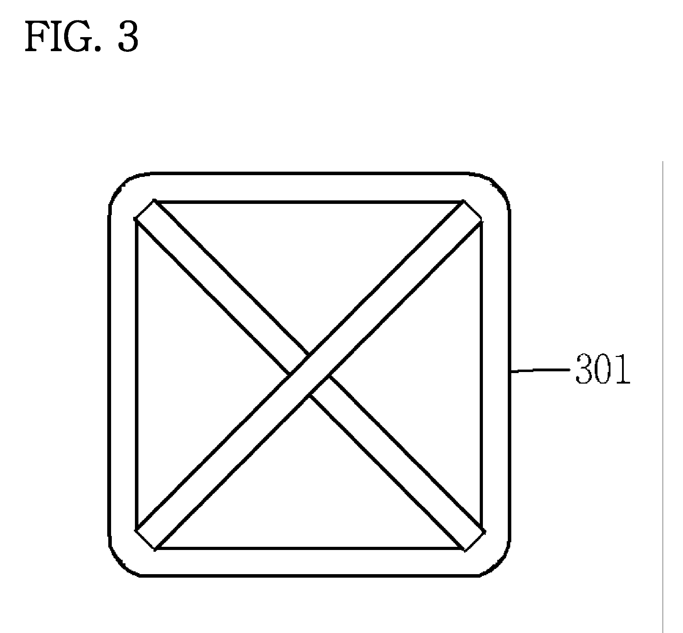

FIG. 3 is a plan view illustrating the induction coil in accordance with another embodiment of the present invention, which illustrates a structure in which a coli is wound in a radial direction in order to increase uniformity.

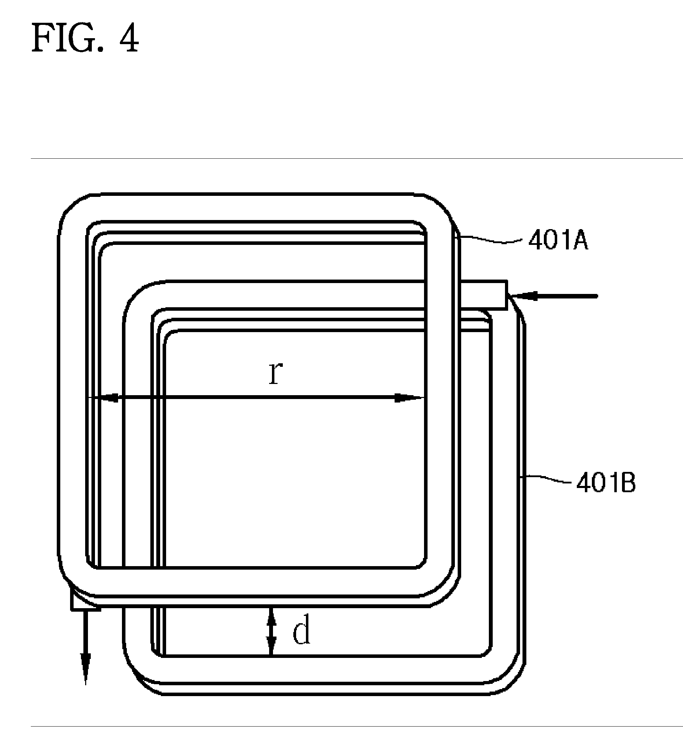

FIG. 4 is a schematic view illustrating the induction coil in accordance with another embodiment of the present invention, which illustrates a structure of a multiple induction coil in order to achieve the uniformity of ion energy and ion density. The multiple induction coil has a structure in which induction coils 401A and 401B having the same shape (e.g., a rectangle) of two groups are connected in parallel to each other. The directions of currents flowing through the induction coils 401A and 401B of the two groups are the same. The number of the groups is not limited to two. For example, the number of the groups may increase as is required.

According to an experimental result, for example, when the ratio of a distance 'r' between right and left windings in the induction coil 401A and an interval 'd' between the induction coils 401A and 401B of the two groups is 1, the uniformity of an etching rate is the highest. The distance and the interval in the induction coils 401A and 401B of the two groups may be the same or different from each other.

However, it is difficult to install the solar cell wafer 102 to be textured between the induction coils 401A and 401B of the two groups. In this regard, as illustrated in FIG. 1, the solar cell wafer 102 is loaded on the cathode 101 in the chamber 103 and the multiple induction coil manufactured as illustrated in FIG. 4 is installed above the solar cell wafer 102. Herein, it is preferred to achieve the uniformity of ion density and energy distribution by appropriately adjusting the interval 'd' between the induction coils 401A and 401B of the two groups.

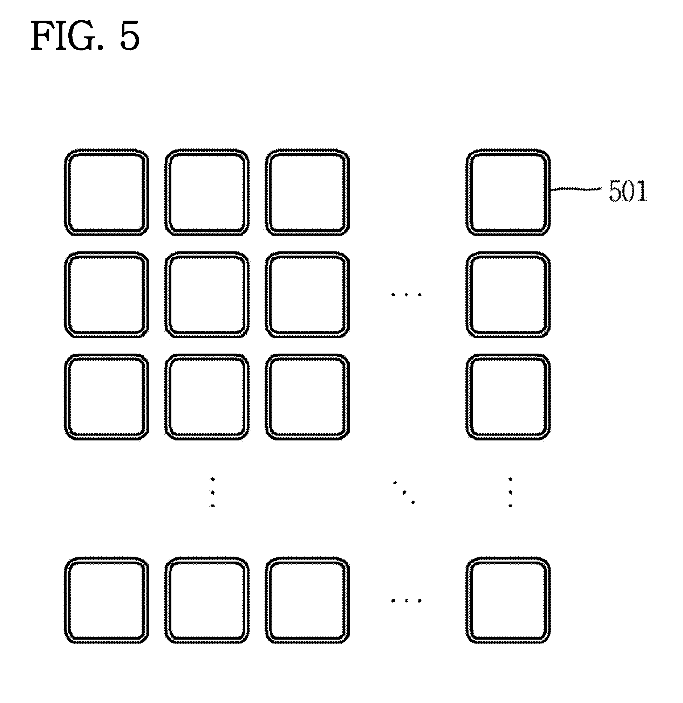

FIG. 5 is a plan view illustrating the induction coil in accordance with another embodiment of the present invention, which illustrates a batch type structure designed such that a plurality of solar cell wafers can be textured at a time. Since a plurality of induction coils 501 arranged in a matrix format independently generate a magnetic field as described above with respect to the solar cell wafers 102 arranged on the cathode 101, texturing can be simultaneously conducted.

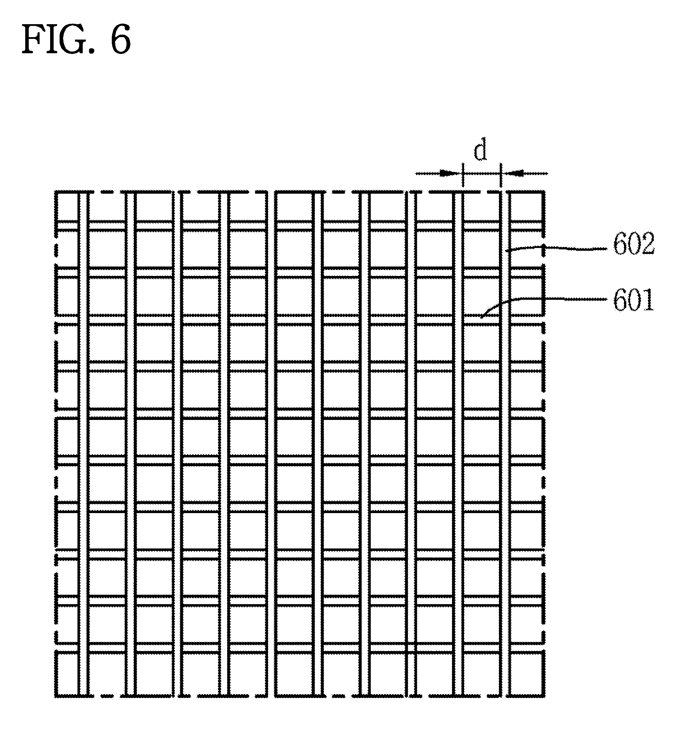

FIG. 6 is a plan view illustrating the induction coil in accordance with another embodiment of the present invention, which illustrates a batch type structure designed such that a plurality of solar cell wafers can be textured at a time. The batch type induction coil includes a plurality of coils 601 arranged in the horizontal direction and a plurality of coils 602 arranged in the vertical direction below or above the coils 601. The interval 'd' between the right and left coils and the height 'h' (not shown) between the upper and lower coils are adjusted, so that ion density and ion energy of each wafer can be individually controlled and the plurality of solar cell wafers can be textured at a time.

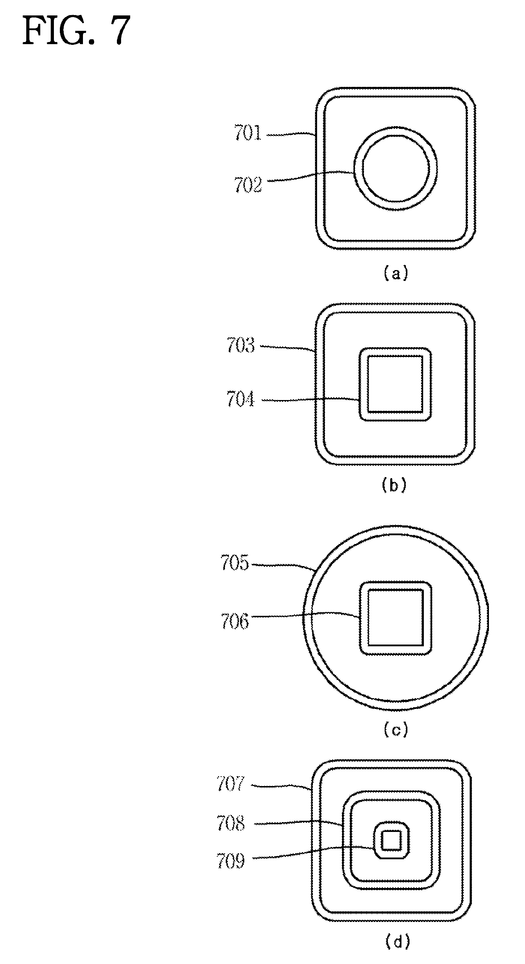

FIGS.7A to 7D are plan views illustrating the induction coil in accordance with another embodiment of the present invention, which illustrate a structure in which an induction coil is additionally provided in the induction coil in order to achieve uniformity of plasma ion density in consideration of the large diameter (e.g., 300 mm, 450 mm) of the solar cell wafer.

FIG. 7A is an example in which a cylindrical induction coil 702 is additionally provided in a rectangular induction coil 701. FIG. 7B is an example in which a rectangular induction coil 704 is additionally provided in a rectangular induction coil 703. FIG. 7C is an example in which a rectangular induction coil 706 is additionally provided in a cylindrical induction coil 705. FIG. 7D is an example in which a rectangular induction coil 708 is additionally provided in a rectangular induction coil 707 and a rectangular induction coil 709 is additionally provided in the rectangular induction coil 708.

In the case of using the induction coil with such a structure, high frequency power, which is supplied from the high frequency source power supply unit 111 to the induction coil provided at an outside, and high frequency power, which is supplied from the high frequency source power supply unit 111 to the induction coil provided at an inside, are independently adjusted using a power distributor (not shown), so that ion density of a corresponding area can be determined at a desired degree.

The present invention is not limited the embodiments illustrated in FIGS.7A to 7D. For example, it may be possible to employ various embodiments in which one or more induction coils having the same shape or different shapes are sequentially provided inside a single induction coil.

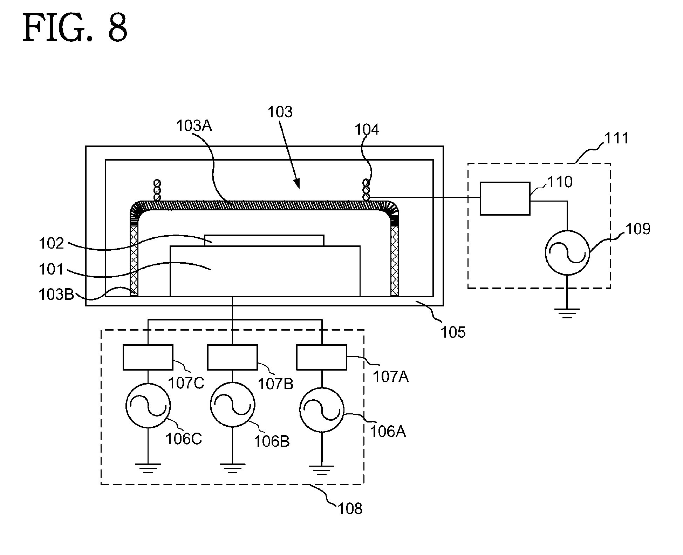

FIG. 8 is a diagram illustrating the high frequency low power supply unit 108 illustrated in FIG. 1 in accordance with another embodiment of the present invention. Referring to FIG. 8, the high frequency low power supply unit 108 includes a plurality of high frequency power generators 106A to 106C and a plurality of high frequency matching sections 107A to 107C, so that the intensity and density of ion energy and radical concentration can be adjusted.

In such a case, high frequency power supplied from the high frequency power generators 106A to 106C can be suitably supplied according to process conditions. For example, the high frequency power generator 106A supplies power of a relatively low frequency (2 MHz), the high frequency power generator 106B supplies power of a relatively high frequency (12.56 MHz to 13.56 MHz), and the high frequency power generator 106C supplies power of a higher frequency (27 MHz to 30 MHz or 60 MHz).

The high frequency power generators 106A to 106C supply power of a relatively low frequency in order to improve the intensity of ion energy, and power of a relatively high frequency in order to improve the density of the ion energy.

The high frequency power supplied from the high frequency power generators 106A to 106C, and the high frequency power supplied from the high frequency power generator 109 in a low dissociation region or a high dissociation region are adjusted, so that the intensity and density of ion energy and radical concentration are adjusted. Consequently, a high etching rate, wide uniformity and a process margin of the solar cell wafer 102 can be ensured.

Among the plurality of high frequency power generators 106A to 106C and the plurality of high frequency matching sections 107A to 107C, desired high frequency power generators and high frequency matching sections can be selectively used according to process conditions.

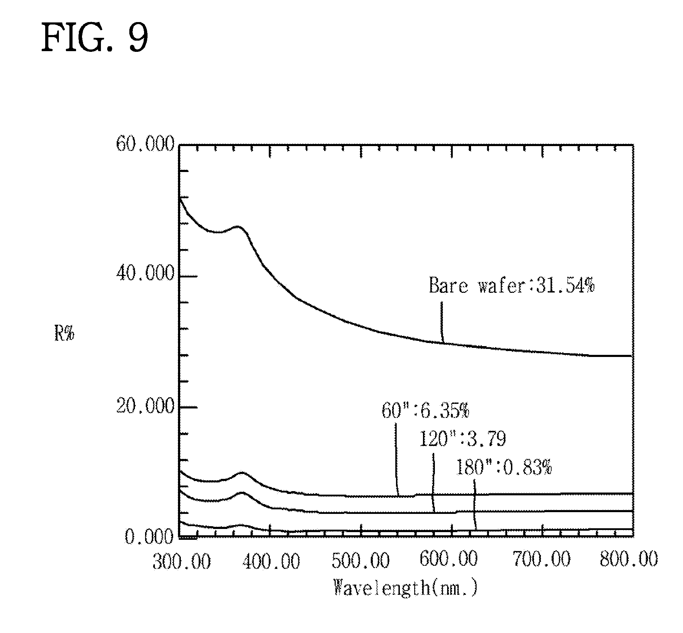

FIG. 9 is a graph illustrating an experimental result for reflectivity of the solar cell wafer in the case of using the plasma texturing reaction apparatus in accordance with the embodiment of the present invention. Referring to FIG. 9, as compared with the case where light reflectivity of a bare wafer is averagely 31.54% in a wavelength range of 300 nm to 800 nm, light reflectivity of the solar cell wafer in accordance with the embodiment of the present invention is reduced as the passage of texturing time and is smaller than 1% at maximum.

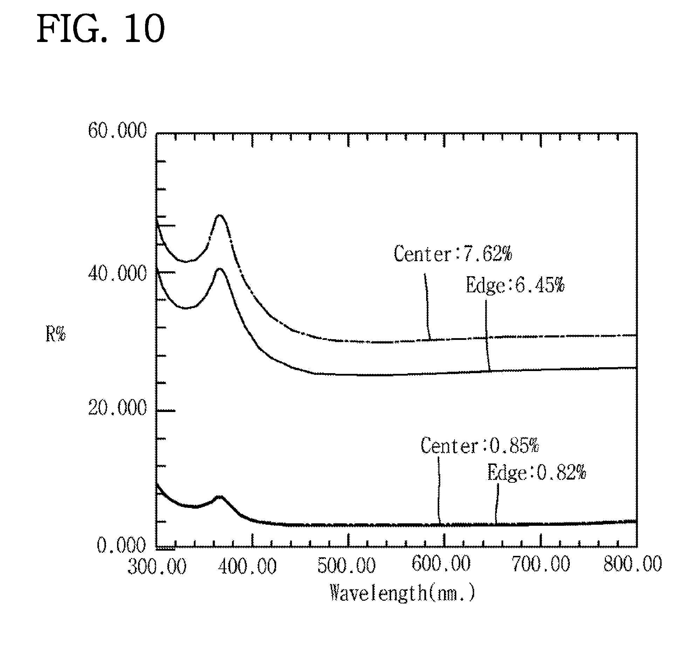

FIG. 10 is a graph illustrating an experimental result for uniformity of the solar cell wafer in the case of using the plasma texturing reaction apparatus in accordance with the embodiment of the present invention. Referring to FIG. 10, in the case of conducting texturing using a general induction coil, the difference of 1% or more occurs in uniformity of a center portion and an edge portion. However, in the case of conducting texturing using the induction coil in accordance with the embodiment of the present invention, uniformity of a center portion and an edge portion is smaller than 0.03%.

In embodiments of the present invention, a magnetic field is generated using a polygonal induction coil when conducting texturing on the surface of ultrathin wafer through dry etching in a process of manufacturing a solar cell, so that etching uniformity is improved from the center portion to an outer peripheral portion of the wafer, resulting in the reduction of reflectivity of the solar cell. As a result, the photoelectric conversion efficiency of the solar cell is improved.

Although an embodiment of the present invention has been described for illustrative purposes, those skilled in the art will appreciate that various modifications, additions and substitutions are possible, without departing from the scope of the invention as recited in the accompanying claims.

## Claims

1. A plasma texturing reaction apparatus comprising:
a chamber including a dielectric window and a chamber body for receiving a solar cell wafer to be textured;
a polygonal induction coil provided at an outer upper portion of the dielectric window to generate a magnetic field for generating plasma;
a high frequency low power supply unit configured to supply a cathode of the chamber with high frequency power corresponding to process conditions; and
a high frequency source power supply unit configured to supply the polygonal induction coil with high frequency power.

2. The plasma texturing reaction apparatus according to claim 1, wherein the polygon is at least a rectangle.

3. The plasma texturing reaction apparatus according to claim 1, wherein the induction coil includes an induction coil having a radial structure.

4. The plasma texturing reaction apparatus according to claim 1, wherein the induction coil includes an induction coil having a structure in which induction coils of a plurality of groups are connected in parallel to one another.

5. The plasma texturing reaction apparatus according to claim 1, wherein the induction coil includes an induction coil having a batch type structure in which a plurality of induction coils are arranged in a matrix format to generate a magnetic field with respect to corresponding solar cell wafers.

6. The plasma texturing reaction apparatus according to claim 1, wherein the induction coil includes an induction coil having a batch type structure in which a plurality of induction coils are arranged in a horizontal direction and a plurality of induction coils are arranged in a vertical direction below or above the plurality of induction coils arranged in the horizontal direction.

7. The plasma texturing reaction apparatus according to claim 1, wherein the induction coil includes an induction coil having a structure in which at least one induction coil having a same shape or different shapes is sequentially provided inside a single induction coil.

8. The plasma texturing reaction apparatus according to claim 7, wherein the single induction coil or the at least one induction coil provided inside the single induction coil includes a polygonal induction coil or a cylindrical induction coil.

9. The plasma texturing reaction apparatus according to claim 7 or 8, wherein the single induction coil or the at least one induction coil provided inside the single induction coil independently adjusts high frequency power radiated under a control of a high frequency power distributor to allow ion density of a corresponding area to be uniformly adjusted at a desired degree.

10. The plasma texturing reaction apparatus according to any preceding claim, wherein the high frequency low power supply unit includes a plurality of high frequency power generators and a plurality of high frequency matching sections to adjust intensity and density of ion energy and radical concentration.

11. The plasma texturing reaction apparatus according to claim 10, wherein the plurality of high frequency power generators are arranged to generate high frequency power with a same frequency or different frequencies.
